# EUROPEAN PATENT SPECIFICATION

(11) **EP 3 345 718 B1**
(45) Date of publication and mention of the grant of the patent: **23.03.2022**
(21) Application number: 17205952.9
(22) Date of filing: 07.12.2017
(51) Int. Cl.: B23P 6/00, B23K 1/00, B23K 1/20, B23K 20/02, B23K 20/16, B23K 35/02, B23K 35/22, B23K 35/30, C23C 2/26, C23C 2/28, C23C 4/18, F01D 5/00, B23K 35/32, C23C 4/02, B23K 101/00, B23K 103/18

(54) **STRUCTURE BRAZE REPAIR OF HARD-TO-WELD SUPERALLOY COMPONENTS USING DIFFUSION ALLOY INSERT**
LÖTREPARATUR EINER STRUKTUR VON SCHWER ZU SCHEISSENDEN SUPERLEGIERUNGSKOMPONENTEN MITTELS DIFFUSIONSLEGIERUNGSEINSATZ
STRUCTURE DE RÉPARATION DE BRASURE DE COMPOSANTS EN SUPERALLIAGE DIFFICILES À SOUDER À L'AIDE D'INSERT D'ALLIAGE PAR DIFFUSION

(30) Priority: 04.01.2017 US 201715397840
(43) Date of publication of application: 11.07.2018
(73) Proprietor: General Electric Company, Schenectady, NY 12345 (US)
(72) Inventor: CUI, Yan, Greenville, SC South Carolina 29615 (US); KOTTILINGAM, Srikanth Chandrudu, Greenville, SC South Carolina 29615 (US); TOLLISON, Brian Lee, Greenville, SC South Carolina 29615 (US); LIN, Dechao, Greenville, SC South Carolina 29615 (US); EMINOGLU, Cem Murat, Greenville, SC South Carolina 29615 (US)
(74) Representative: Novagraaf Group

(56) References cited:
- EP-A1- 2 078 579
- DE-A1-102013 224 103
- US-A1- 2003 034 379
- US-A1- 2015 047 168

## Description

### FIELD OF THE INVENTION

The present invention is directed to a repair of hard-to-weld superalloy components, and more specifically to a structural braze repair of hard-to-weld superalloy components using diffusion alloy insert.

### BACKGROUND OF THE INVENTION

Gas turbine machines typically use high strength and oxidation resistant hard-to-weld (HTW) alloys to fabricate hot gas path components, such as airfoils, buckets, blades, nozzles, vanes, shrouds, rotating turbine components, wheels, seals, combustor liners, 3D-manufactured components and transition ducts. Hard-to-weld (HTW) alloys typically show desirable mechanical properties for turbine operating temperatures and conditions.

However, during operation, components formed from hard-to-weld (HTW) alloys experience severe working environment, and material degradation will occur due to fatigue, creep, corrosion or oxidization.

Brazing has been largely used to rejuvenate service-run parts. Brazing shows a great mechanical strength only if the brazing gap size is very narrow in the brazing joint. Otherwise, brazing does not provide service-run parts with a sufficiently high mechanical strength for operation. However, in the production, it is hard to control the gap size to the desired dimension.

Yet, no engineering practice has been reported to disclose a method to provide the service-run parts with a great mechanical strength with a controlled narrow brazing gap size.

EP 2078579 A1 discloses a repairing method which comprises bringing a solder insert into a hole of a substrate of a component, connecting the solder insert with the substrate using a soldering material in a gap by melting, and welding the gap between the solder insert and the substrate on height of the surface of the substrate, so that a welded joint or welding seam is formed on the height of the surface.

### BRIEF SUMMARY OF THE INVENTION

The invention is defined by the appended claims. It provides a method for treating a superalloy turbine component in accordance with claim 1 and a treated superalloy turbine component in accordance with claim 14. In the following description, anything referred to as an embodiment which does not fall within the scope of the claims is to be understood as an example useful for understanding the invention.

Other features and advantages of the present invention will be apparent from the following more detailed description, taken in conjunction with the accompanying drawings which illustrate, by way of example, the principles of the invention.

### BRIEF DESCRIPTION OF THE DRAWINGS

FIG. 1 is a flow chart illustrating one embodiment of a method of treating a component.
FIG. 2 is a perspective view of a component including a treatment region.
FIG. 3 shows a schematic view of a method according to the present invention.

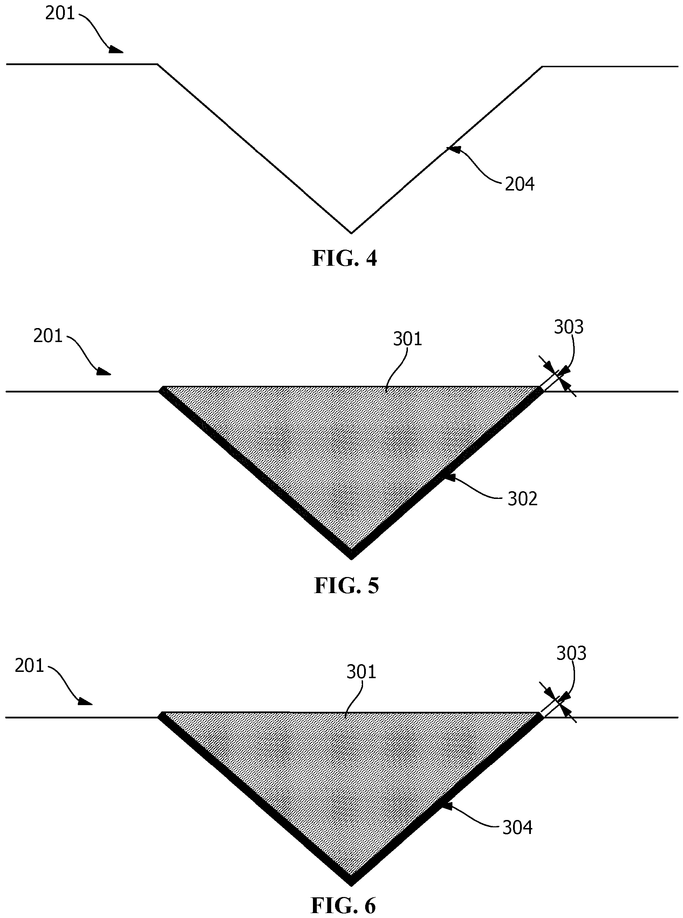

FIG. 4 is a cross-section view taken along line 4-4 in FIG. 3.
FIG. 5 is a cross-section view taken along line 5-5 in FIG. 3.
FIG. 6 is a cross-section view taken along line 6-6 in FIG. 3.

Wherever possible, the same reference numbers will be used throughout the drawings to represent the same parts.

### DETAILED DESCRIPTION OF THE INVENTION

All numbers expressing quantities of ingredients and/or reaction conditions are to be understood as being modified in all instances by the term "about", unless otherwise indicated.

The articles "a" and "an," as used herein, mean one or more when applied to any feature in embodiments of the present invention described in the specification and claims. The use of "a" and "an" does not limit the meaning to a single feature unless such a limit is specifically stated. The article "the" preceding singular or plural nouns or noun terms denotes a particular specified feature or particular specified features and may have a singular or plural connotation depending upon the context in which it is used. The adjective "any" means one, some, or all indiscriminately of whatever quantity.

All percentages and ratios are calculated by weight unless otherwise indicated. All percentages are calculated based on the total weight of a composition unless otherwise indicated. All component or composition levels are in reference to the active level of that component or composition, and are exclusive of impurities, for example, residual solvents or by-products, which may be present in commercially available sources.

The term "tapered", as used herein, and variations of this term, refer to any shape diminishing, reducing, or causing to diminish or reduce in thickness toward one end. In some embodiments, the cross section of "tapered" shape may include, but not be limited to, a V-shape and a U-shape.

The term "machining", as used herein, and variations of this term, refer to any process that is capable of controllably removing material from a component. Examples of machining include, but are not limited to post-fabrication drilling, electrical discharge machining (EDM), laser drilling, mechanical drilling, vibrational drilling, milling, computer numerical control milling, water jet cutting, abrasive jet cutting, punching, formation by an additive manufacturing technique, 3D printing, or combinations thereof.

The present invention may comprise an embodiment including a method for treating a component with a controlled narrow brazing gap size to provide the component with a great mechanical strength. The component herein illustrated may comprise a metal or an alloy. The alloy may comprise a superalloy. The term "superalloy" is used herein as it is commonly used in the art; i.e., a highly corrosion and oxidation resistant alloy that exhibits excellent mechanical strength and resistance to creep at high temperatures.

In some embodiments, the component may include, but not be limited to, a single crystal (SX) material, a directionally solidified (DS) material, an equiaxed crystal (EX) material, and combinations thereof.

In some embodiments, the superalloy may include nickel-based superalloy, cobalt-based superalloy, iron-based superalloy, titanium-based superalloy, or combinations thereof. The superalloy may include, but not be limited to, a material selected from the group consisting of Hastelloy, Inconel alloys, Waspaloy, Rene alloys, such as GTD111, GTD222, GTD444, GTD262, Mar M247, IN100, IN 738, René 80, IN 939, René N2, René N4, René N5, René N6, René 65, René 77 (Udimet 700), René 80, René 88DT, René 104, René 108, René 125, René 142, René 195, René N500, René N515, IN 706, Nimonic 263, CM247, MarM247, CMSX-4, MGA1400, MGA2400, INCONEL 700, INCONEL 738, INCONEL 792, DS Siemet, CMSX10, PWA1480, PWA1483, PWA1484, TMS-75, TMS-82, Mar-M-200, UDIMET 500, ASTROLOY, and combinations thereof.

As used herein, "ASTROLOY" refers to an alloy including a composition, by weight, of about 15% chromium, about 17% cobalt, about 5.3% molybdenum, about 4% aluminum, about 3.5% titanium, and a balance of nickel.

As used herein, "DS Siemet" refers to an alloy including a composition, by weight, of about 9% cobalt, about 12.1% chromium, about 3.6% aluminum, about 4% titanium, about 5.2% tantalum, about 3.7% tungsten, about 1.8% molybdenum, and a balance of nickel.

As used herein, "GTD111" refers to an alloy including a composition, by weight, of about 14% chromium, about 9.5% cobalt, about 3.8% tungsten, about 4.9% titanium, about 3% aluminum, about 0.1% iron, about 2.8% tantalum, about 1.6% molybdenum, about 0.1% carbon, and a balance of nickel.

As used herein, "GTD262" refers to an alloy including a composition, by weight, of about 22.5% chromium, about 19% cobalt, about 2% tungsten, about 1.35% niobium, about 2.3% titanium, about 1.7% aluminum, about 0.1% carbon, and a balance of nickel.

As used herein, "GTD444" refers to an alloy including a composition, by weight, of about 7.5% cobalt, about 0.2% iron, about 9.75% chromium, about 4.2% aluminum, about 3.5% titanium, about 4.8% tantalum, about 6% tungsten, about 1.5% molybdenum, about 0.5% niobium, about 0.2% silicon, about 0.15% hafnium, and a balance of nickel.

As used herein, "MGA1400" refers to an alloy including a composition, by weight, of about 10% cobalt, about 14% chromium, about 4% aluminum, about 2.7% titanium, about 4.7% tantalum, about 4.3% tungsten, about 1.5% molybdenum, about 0.1% carbon, and a balance of nickel.

As used herein, "MGA2400" refers to an alloy including a composition, by weight, of about 19% cobalt, about 19% chromium, about 1.9% aluminum, about 3.7% titanium, about 1.4% tantalum, about 6% tungsten, about 1% niobium, about 0.1% carbon, and a balance of nickel.

As used herein, "PMA 1480" refers to an alloy including a composition, by weight, of about 10% chromium, about 5% cobalt, about 5% aluminum, about 1.5% titanium, about 12% tantalum, about 4% tungsten, and a balance of nickel.

As used herein, "PWA1483" refers to an alloy including a composition, by weight, of about 9% cobalt, about 12.2% chromium, about 3.6% aluminum, about 4.1% titanium, about 5% tantalum, about 3.8% tungsten, about 1.9% molybdenum, and a balance of nickel.

As used herein, "PMA 1484" refers to an alloy including a composition, by weight, of about 5% chromium, about 10% cobalt, about 2% molybdenum, about 5.6% aluminum, about 9% tantalum, about 6% tungsten, and a balance of nickel.

As used herein, "René N2" refers to an alloy including a composition, by weight, of about 7.5% cobalt, about 13% chromium, about 6.6% aluminum, about 5% tantalum, about 3.8% tungsten, about 1.6% rhenium, about 0.15% hafnium, and a balance of nickel.

As used herein, "René N4" refers to an alloy including a composition, by weight, of about 9.75% chromium, about 7.5% cobalt, about 4.2% aluminum, about 3.5% titanium, about 1.5% molybdenum, about 6.0% tungsten, about 4.8% tantalum, about 0.5% niobium, about 0.15% hafnium, and a balance of nickel.

As used herein, "René N5" refers to an alloy including a composition, by weight, of about 7.5% cobalt, about 7.0% chromium, about 6.5% tantalum, about 6.2% aluminum, about 5.0% tungsten, about 3.0% rhenium, about 1.5% molybdenum, about 0.15% hafnium, and a balance of nickel.

As used herein, "René N6" refers to an alloy including a composition, by weight, of about 12.5% cobalt, about 4.2% chromium, about 7.2% tantalum, about 5.75% aluminum, about 6% tungsten, about 5.4% rhenium, about 1.4% molybdenum, about 0.15% hafnium, and a balance of nickel.

As used herein, "René 65" refers to an alloy including a composition, by weight, of about 13% cobalt, up to about 1.2% iron, about 16% chromium, about 2.1% aluminum, about 3.75% titanium, about 4% tungsten, about 4% molybdenum, about 0.7% niobium, up to about 0.15% manganese, and a balance of nickel.

As used herein, "René 77 (Udimet 700)" refers to an alloy including a composition, by weight, of about 15% chromium, about 17% cobalt, about 5.3% molybdenum, about 3.35% titanium, about 4.2% aluminum, and a balance of nickel.

As used herein, "René 80" refers to an alloy including a composition, by weight, of about 14% chromium, about 9.5% cobalt, about 4% molybdenum, about 3% aluminum, about 5% titanium, about 4% tungsten, about 0.17% carbon, and a balance of nickel.

As used herein, "René 88DT" refers to an alloy including a composition, by weight, of about 16% chromium, about 13% cobalt, about 4% molybdenum, about 0.7% niobium, about 2.1% aluminum, about 3.7% titanium, about 4% tungsten, about 0.1% rhenium, a maximum of about 4.3% rhenium and tungsten, and a balance of nickel.

As used herein, "René 104" refers to an alloy including a composition, by weight, of about 13.1% chromium, about 18.2% cobalt, about 3.8% molybdenum, about 1.9% tungsten, about 1.4% niobium, about 3.5% aluminum, about 3.5% titanium, about 2.7% tantalum, and a balance of nickel.

As used herein, "René 108" refers to an alloy including a composition, by weight, of about 8.4% chromium, about 9.5% cobalt, about 5.5% aluminum, about 0.7% titanium, about 9.5% tungsten, about 0.5% molybdenum, about 3% tantalum, about 1.5% hafnium, and a balance of nickel.

As used herein, "René 125" refers to an alloy including a composition, by weight, of about 8.5% chromium, about 10% cobalt, about 4.8% aluminum, up to about 2.5% titanium, about 8% tungsten, up to about 2% molybdenum, about 3.8% tantalum, about 1.4% hafnium, about 0.11% carbon, and a balance of nickel.

As used herein, "René 142" refers to an alloy including a composition, by weight, of about 6.8% chromium, about 12% cobalt, about 6.1% aluminum, about 4.9% tungsten, about 1.5% molybdenum, about 2.8% rhenium, about 6.4% tantalum, about 1.5% hafnium, and a balance of nickel.

As used herein, "René 195" refers to an alloy including a composition, by weight, of about 7.6% chromium, about 3.1% cobalt, about 7.8% aluminum, about 5.5% tantalum, about 0.1% molybdenum, about 3.9% tungsten, about 1.7% rhenium, about 0.15% hafnium, and a balance of nickel.

As used herein, "René N500" refers to an alloy including a composition, by weight, of about 7.5% cobalt, about 0.2% iron, about 6% chromium, about 6.25% aluminum, about 6.5% tantalum, about 6.25% tungsten, about 1.5% molybdenum, about 0.15% hafnium, and a balance of nickel.

As used herein, "René N515" refers to an alloy including a composition, by weight, of about 7.5% cobalt, about 0.2% iron, about 6% chromium, about 6.25% aluminum, about 6.5% tantalum, about 6.25% tungsten, about 2% molybdenum, about 0.1% niobium, about 1.5% rhenium, about 0.6% hafnium, and a balance of nickel.

As used herein, "MarM247" and "CM247" refer to an alloy including a composition, by weight, of about 5.5% aluminum, about 0.15% carbon, about 8.25% chromium, about 10% cobalt, about 10% tungsten, about 0.7% molybdenum, about 0.5% iron, about 1% titanium, about 3% tantalum, about 1.5% hafnium, and a balance of nickel.

As used herein, "IN100" refers to an alloy including a composition, by weight, of about 10% chromium, about 15% cobalt, about 3% molybdenum, about 4.7% titanium, about 5.5% aluminum, about 0.18% carbon, and a balance of nickel.

As used herein, "INCONEL 700" refers to an alloy including a composition, by weight, of up to about 0.12% carbon, about 15% chromium, about 28.5% cobalt, about 3.75% molybdenum, about 2.2% titanium, about 3% aluminum, about 0.7% iron, up to about 0.3% silicon, up to about 0.1% manganese, and a balance of nickel.

As used herein, "INCONEL 738" refers to an alloy including a composition, by weight, of about 0.17% carbon, about 16% chromium, about 8.5% cobalt, about 1.75% molybdenum, about 2.6% tungsten, about 3.4% titanium, about 3.4% aluminum, about 0.1% zirconium, about 2% niobium, and a balance of nickel.

As used herein, "INCONEL 792" refers to an alloy including a composition, by weight, of about 12.4% chromium, about 9% cobalt, about 1.9% molybdenum, about 3.8% tungsten, about 3.9% tantalum, about 3.1% aluminum, about 4.5% titanium, about 0.12% carbon, about 0.1% zirconium, and a balance of nickel.

As used herein, "UDIMET 500" refers to an alloy including a composition, by weight, of about 18.5% chromium, about 18.5% cobalt, about 4% molybdenum, about 3% titanium, about 3% aluminum, and a balance of nickel.

As used herein, "Mar-M-200" refers to an alloy including a composition, by weight, of about 9% chromium, about 10% cobalt, about 12.5% tungsten, about 1% niobium, about 5% aluminum, about 2% titanium, about 10.14% carbon, about 1.8% hafnium, and a balance of nickel.

As used herein, "TMS-75" refers to an alloy including a composition, by weight, of about 3% chromium, about 12% cobalt, about 2% molybdenum, about 6% tungsten, about 6% aluminum, about 6% tantalum, about 5% rhenium, about 0.1% hafnium, and a balance of nickel.

As used herein, "TMS-82" refers to an alloy including a composition, by weight, of about 4.9% chromium, about 7.8% cobalt, about 1.9% molybdenum, about 2.4% rhenium, about 8.7% tungsten, about 5.3% aluminum, about 0.5% titanium, about 6% tantalum, about 0.1% hafnium, and a balance of nickel.

As used herein, "CMSX-4" refers to an alloy including a composition, by weight, of about 6.4% chromium, about 9.6% cobalt, about 0.6% molybdenum, about 6.4% tungsten, about 5.6% aluminum, about 1.0% titanium, about 6.5% tantalum, about 3% rhenium, about 0.1% hafnium, and a balance of nickel.

As used herein, "CMSX-10" refers to an alloy including a composition, by weight, of about 2% chromium, about 3% cobalt, about 0.4% molybdenum, about 5% tungsten, about 5.7% aluminum, about 0.2% titanium, about 8% tantalum, about 6% rhenium, and a balance of nickel.

Any of the alloy compositions described herein may include incidental impurities.

A method to fabricate a diffusion alloy insert utilized for brazing structural joints with a controlled narrow gap size is provided. The method may effectively conduct structural repair of hard-to-weld superalloy. This method may be also utilized for any geometry of insert, and minimize the amount of damaged and/or cracked casting base metal to be removed.

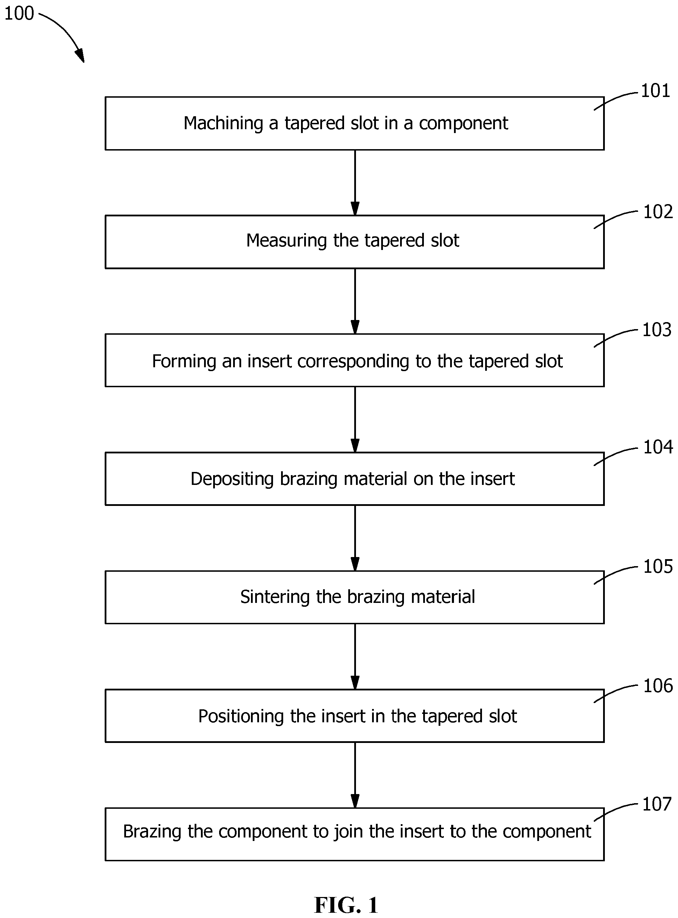

With reference to FIG. 1, a flow chart illustrating a method for treating a component is provided. The method for treating a component includes a step 101 of machining a tapered slot in the component to remove a defect-containing portion of the component. In a step 102, the tapered slot is measured to determine the tapered slot dimension. In a step 103, an insert is formed to have a corresponding geometry to the tapered slot with a braze gap between an outer surface of the insert and an inner surface of the tapered slot. In a step 104, a layer of a braze material is deposited on the outer surface of the insert, where a thickness of the layer corresponds to the braze gap. In a step 105, the layer of the braze material is sintered on the outer surface of the insert to fabricate a diffusion layer. In a step 106, the insert is positioned into the tapered slot. In a step 107, the component is brazed to join the insert to the taper slot of the component.

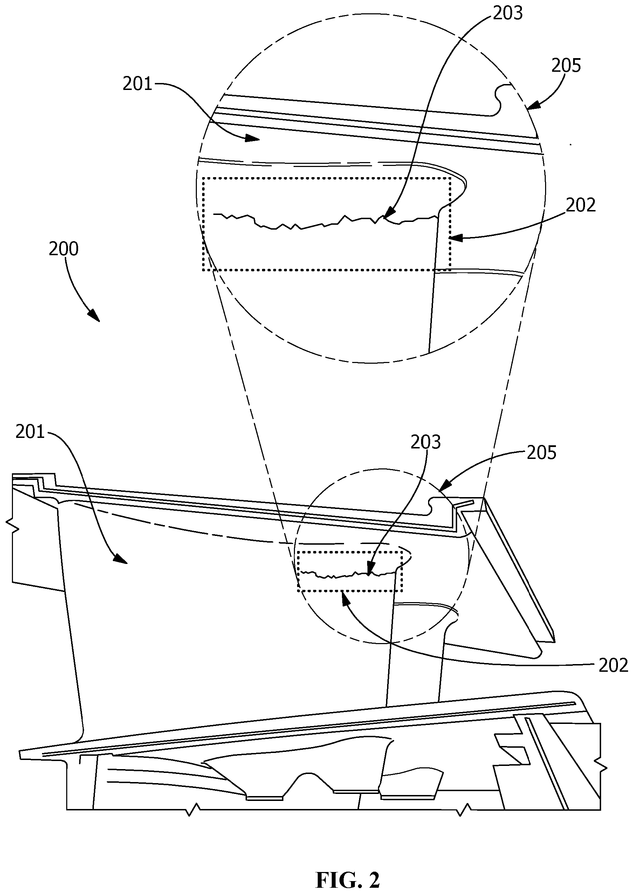

With reference to FIG. 2, a component 201 of a treatment system 200 includes a treatment region 202. The component 201 may be fabricated from any suitable metal or alloy. For example, suitable metals for use as component 201 include but are not limited to superalloys. In particular, component 201 may include nickel cobalt iron-based or titanium based superalloys. The metal alloys may comprise superalloys. The treatment region 202 includes a damaged and/or cracked portion 203. Enlarged portion 205 shows a magnified view of treatment region 202. In some embodiments, the damaged and/or cracked portion 203 may include, but not be limited to, a leading edge, or trailing edge cracks.

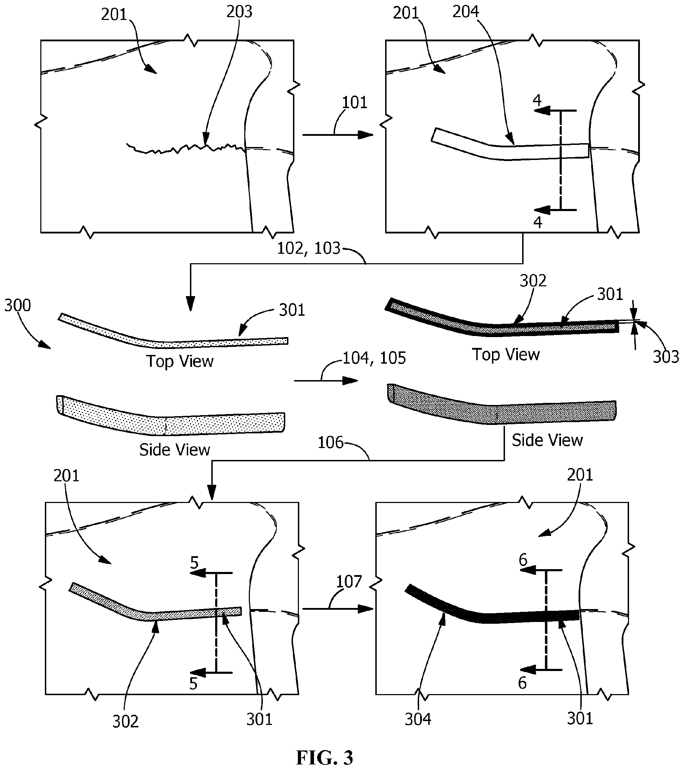

With reference to FIGs. 1 and 3, the method for treating a component 201 includes machining a tapered slot 204 in the component 201 to remove a defect-containing portion of the component 201 (step 101).

For example, the machining may include post-fabrication drilling, electrical discharge machining (EDM), laser drilling, mechanical drilling, vibrational drilling, milling, computer numerical control milling, water jet cutting, abrasive jet cutting, punching, formation by an additive manufacturing technique, 3D printing, or combinations thereof.

The method further includes measuring tapered slot 204 to determine the tapered slot dimensions (step 102). In certain embodiments, the measuring may further include measuring techniques, such as, but not be limited to, utilizing a white light 3D measurement system, a blue light 3D measurement system, a laser based measuring system, or combinations thereof. The method further includes forming an insert 301 of an insert system 300 to have a corresponding geometry to the tapered slot 204 (step 103). Insert 301 is formed with a geometry that provides a braze gap 303 between an outer surface of the insert 301 and an inner surface of the tapered slot 204, when insert 301 is inserted in tapered slot 204. In one embodiment, the tapered slot dimensions may be determined, for example, by a blue light 3D measurement system.

The forming 103 may include, but not be limited to post-fabrication drilling, electrical discharge machining (EDM), laser drilling, mechanical drilling, vibrational drilling, milling, computer numerical control milling, water jet cutting, abrasive jet cutting, punching, formation by an additive manufacturing technique, 3D printing, or combinations thereof. In one embodiment, the forming includes machining a material to the designed geometry.

The braze gap 303 may be formed between the insert 301 and the inner surface of tapered slot 204 sufficiently small to provide a tensile strength greater than about 500 MPa at room temperature. Thus, in various embodiments, the braze gap may be sufficiently small to provide a tensile strength greater than 600 MPa, greater than 700 MPa, and greater than 800 MPa, greater than 900 MPa, and greater than 1000 MPa at room temperature. In one embodiment, the braze gap may be between about 0.0127 and 0.254 mm (0.0005 inches and 0.01 inches). Thus, in various embodiments, the braze gap may be from about 0.0127 to about 0.254 mm (about 0.0005 to about 0.010 inches), from about 0.0254 to about 0.2413 mm (about 0.0010 to about 0.0095 inches), from about 0.0381 to about 0.2286 mm (about 0.0015 to about 0.0090 inches), from about 0.0508 to 0.2159 mm (about 0.0020 to about 0.0085 inches), from about 0.0635 to about 0.2032 mm (about 0.0025 to about 0.0080 inches), from about 0.0762 to about 0.1905 mm (about 0.0030 to about 0.0075 inches), from about 0.0889 to about 0.1651 mm (about 0.0035 to about 0.0065 inches), from about 0.1016 to about 0.1524 mm about 0.0040 to about 0.0060 inches, or from about 0.1143 to about 0.1397 mm (about 0.0045 to about 0.0055 inches), including increments and intervals therein.

The insert 301 may include, but not be limited to, a single crystal (SX) material, a directionally solidified (DS) material, an equiaxed crystal (EX) material, and combinations thereof. In one embodiment, insert 301 includes a material that is the same as a material of component 201. In another embodiment, insert 301 includes a material that is dissimilar from a material of component 201.

Also with to FIG. 3, the method includes depositing a layer of braze material on the outer surface of the insert (step 104). In one embodiment, the thickness of the layer may correspond to the braze gap 303 between the outer surface of the insert 301 and the inner surface of tapered slot 204. The depositing may include, but not be limited to, powder spray, tape or foil deposition, physical vapor deposition (PVD), chemical vapor deposition (CVD), thermal spray, electrodeposition, hot dipping, cold dipping, laser based deposition, welding based deposition, and combinations thereof. Braze material may include, but not be limited to, gold, copper, silver, platinum, palladium, nickel, titanium, vanadium, zirconium, cobalt, and combinations thereof. The method includes sintering the layer of braze material on the outer surface of the insert 301 to fabricate diffusion layer 302 (step 105).

Sintering may be conducted at a temperature between about 982 and about 1260°C (about 1800 and about 2300° F). Thus, in various embodiments, the sintering may be conducted at a temperature from about 982 to about 1260°C (about 1800 to about 2300° F), from about 1010 to about 1232°C (about 1850 to about 2250° F), from about 1038 to about 1204°C (about 1900 to about 2200° F), from about 1066 to about 1177°C (about 1950 to about 2150° F), or from about 1093 to about 1149°C (about 2000 to about 2100° F), preferably from about 1038 to about 1191°C (about 1900 to about 2175° F), including increments and intervals therein. The sintering may be conducted in inert gas environment. The sintering, for example, may be conducted in either a vacuum or hydrogen furnace. The sintering temperature may be sufficient to transform the layer of braze material into diffusion layer 302.

The method further includes positioning the insert 301 with the diffusion layer 302 into the tapered slot 204 (step 106). The insert 301 may be positioned into the tapered slot 204 with tight/press fit.

The method further includes brazing diffusion layer 302 to join insert 301 to the component 201 (step 107). The brazing may be conducted at a temperature sufficient to melt at least a portion of diffusion layer 302 but not the component 201. The melt portion of diffusion layer 302 may bond the insert 301 to the component 201 with a narrow braze gap size. Thus, in various embodiments, the brazing may be conducted at a temperature from about 982 to about 1288°C (about 1800 to about 2350° F), from about 1010 to about 1260°C (about 1850 to about 2300 ° F), from about 1038 to about 1232°C (about 1900 to about 2250° F), from about 1066 to about 1204°C (about 1950 to about 2200 ° F), from about 1093 to about 1177°C (about 2000 to about 2150° F), or from about 1121 to about 1149°C (about 2050 to about 2100° F), including increments and intervals therein. In one embodiment, the brazing may be conducted at a temperature between about 982 and about 1288°C (about 1800 and about 2350° F), preferably from about 1121 to about 1218°C (about 2050 to about 2225° F). The brazing may be conducted along with a thermal cycle.

## Claims

1. A method (100) for treating a superalloy turbine component (201) comprising the steps of:
machining (101) a tapered slot (204) in the component (201) to remove a portion (203) of the component (201);
measuring (102) the tapered slot (204) to determine the tapered slot (204) dimensions;
forming (103) an insert (301) to have a corresponding geometry to the tapered slot (204) with a braze gap (303) ranging from 0.0127 to 0.254 mm (0.0005 to 0.01 inches) between an outer surface of the insert (301) and an inner surface of the tapered slot (204);
depositing (104) a layer of a braze material on the outer surface of the insert (301);
sintering (105) the layer of the braze material on the outer surface of the insert (301) to fabricate a diffusion layer (302);
positioning (106) the insert (301) into the tapered slot (204); and
brazing (107) the component (201) to join the insert (301) to the component (201).

2. The method (100) of claim 1, wherein the measuring (102) comprises utilizing a measurement system selected from the group consisting of white light 3D measurement system, a blue light 3D measurement system, a laser based measuring system, and combinations thereof.

3. The method (100) of claim 1 or 2, wherein the forming (103) the insert (301) comprises a process selected from the group consisting of post-fabrication drilling, electrical discharge machining (EDM), laser drilling, mechanical drilling, vibrational drilling, milling, computer numerical control milling, water jet cutting, abrasive jet cutting, punching, formation by an additive manufacturing technique, 3D printing, and combinations thereof.

4. The method (100) of any one of claims 1 to 3, wherein the depositing (104) comprises a process selected from the group consisting of powder spray, tape or foil deposition, physical vapor deposition (PVD), chemical vapor deposition (CVD), thermal spray, electrodeposition, hot dipping, cold dipping, laser based deposition, welding based deposition, and combinations thereof.

5. The method (100) of any one of claims 1 to 4, wherein a thickness of the layer is the same as the braze gap (303) spaced between the outer surface of the insert (301) and the inner surface of the tapered slot (204).

6. The method (100) of any one of claims 1 to 5, wherein the component (201) comprises a superalloy material selected from the group consisting of nickel-based superalloy, cobalt-based superalloy, iron-based superalloy, titanium-based superalloy, and combinations thereof.

7. The method (100) of any one of claims 1 to 6, wherein the component (201) comprises a material selected from the group consisting of a single crystal (SX) material, a directionally solidified (DS) material, an equiaxed crystal (EX) material, and combinations thereof.

8. The method (100) of any one of claims 1 to 7, wherein the insert (301) comprises a material selected from the group consisting of a single crystal (SX) material, a directionally solidified (DS) material, an equiaxed crystal (EX) material, and combinations thereof.

9. The method (100) of any one of claims 1 to 8, wherein the braze gap (303) is sufficiently small to provide a tensile strength of greater than 500 MPa at room temperature.

10. The method (100) of any one of claims 1 to 9, wherein the braze material comprises a material selected from the group consisting of gold, copper, silver, platinum, palladium, nickel, titanium, vanadium, zirconium, cobalt, and combinations thereof.

11. The method (100) of any one of claims 1 to 10, wherein the sintering (105) is conducted at a temperature between 982 and 1260°C (1800 and 2300° F).

12. The method (100) of any one of claims 1 to 11, wherein the brazing (107) is conducted at a temperature between 982 and 1288°C (1800 and 2350° F).

13. The method (100) of any one of claims 1 to 12, wherein the component (201) is a turbine component (201) selected from the group consisting of at least one of blades (buckets), vanes (nozzles), shrouds, combustor liners, and transition ducts.

14. A treated superalloy turbine component (201) comprising:
a surface having a tapered slot (204);
an insert (301) positioned into the tapered slot (204) with a braze gap (303) ranging from 0.0127 to 0.254 mm (0.0005 to 0.01 inches) between an outer surface of the insert (301) and an inner surface of the tapered slot (204); and
a braze joint comprising a braze material positioned in the braze gap (303), the braze material having been sintered on the outer surface of the insert (301), the superalloy turbine component (201) having a diffusion layer (302) between the insert (301) and the superalloy turbine component (201).

## Patentansprüche

1. Verfahren (100) zur Behandlung einer Superlegierungsturbinenkomponente (201), umfassend die folgenden Schritte:
Bearbeiten (101) eines sich verjüngenden Schlitzes (204) in der Komponente (201), um einen Abschnitt (203) der Komponente (201) zu entfernen;
Messen (102) des sich verjüngenden Schlitzes (204), um die Abmessungen des sich verjüngenden Schlitzes (204) zu bestimmen;
Bilden (103) eines Einsatzes (301) derart, dass dieser eine entsprechende Geometrie zu dem sich verjüngenden Schlitz (204) aufweist mit einem Lötspalt (303) im Bereich von 0,0127 bis 0,254 mm (0,0005 bis 0,01 Zoll) zwischen einer Außenfläche des Einsatzes (301) und einer Innenfläche des sich verjüngenden Schlitzes (204);
Abscheiden (104) einer Schicht eines Hartlötmaterials auf der Außenfläche des Einsatzes (301);
Sintern (105) der Schicht des Hartlötmaterials auf der Außenfläche des Einsatzes (301) zum Herstellen einer Diffusionsschicht (302);
Positionieren (106) des Einsatzes (301) in den sich verjüngenden Schlitz (204); und
Hartlöten (107) der Komponente (201) zum Verbinden des Einsatzes (301) mit der Komponente (201).

2. Verfahren (100) nach Anspruch 1, wobei das Messen (102) das Verwenden eines Messsystems umfasst, das aus der Gruppe bestehend aus einem Weißlicht-3D-Messsystem, einem Blaulicht-3D-Messsystem, einem laserbasierten Messsystem und Kombinationen davon ausgewählt ist.

3. Verfahren (100) nach Anspruch 1 oder 2, wobei das Bilden (103) des Einsatzes (301) einen Prozess umfasst, der aus der Gruppe bestehend aus Bohren nach der Herstellung, Elektroerosionsbearbeitung (EDM), Laserbohren, mechanischem Bohren, Vibrationsbohren, Fräsen, computergesteuertem Fräsen, Wasserstrahlschneiden, Schleifstrahlschneiden, Stanzen, Formen durch eine additive Fertigungstechnik, 3D-Drucken und Kombinationen davon ausgewählt ist.

4. Verfahren (100) nach einem der Ansprüche 1 bis 3, wobei das Abscheiden (104) einen Prozess umfasst, der aus der Gruppe bestehend aus Pulversprühen, Band- oder Folienabscheidung, physikalischer Gasphasenabscheidung (PVD), chemischer Gasphasenabscheidung (CVD)., thermischem Spritzen, Elektroabscheidung, Heißtauchen, Kalttauchen, Abscheidung auf Laserbasis, Abscheidung auf Schweißbasis und Kombinationen davon ausgewählt ist.

5. Verfahren (100) nach einem der Ansprüche 1 bis 4, wobei eine Dicke der Schicht dieselbe ist wie die des Abstandes des Lötspalts (303) zwischen der Außenfläche des Einsatzes (301) und der Innenfläche des sich verjüngenden Schlitzes (204).

6. Verfahren (100) nach einem der Ansprüche 1 bis 5, wobei die Komponente (201) ein Superlegierungsmaterial umfasst, das aus der Gruppe bestehend aus einer Superlegierung auf Nickelbasis, einer Superlegierung auf Kobaltbasis, einer Superlegierung auf Eisenbasis, einer Superlegierung auf Titanbasis und Kombinationen davon ausgewählt ist.

7. Verfahren (100) nach einem der Ansprüche 1 bis 6, wobei die Komponente (201) ein Material umfasst, das aus der Gruppe bestehend aus einem Einkristall-(SX)-Material, einem gerichtet erstarrten (DS)-Material, einem gleichachsigen Kristall (EX)-Material und Kombinationen davon ausgewählt ist.

8. Verfahren (100) nach einem der Ansprüche 1 bis 7, wobei der Einsatz (301) ein Material umfasst, das aus der Gruppe bestehend aus einem Einkristall-(SX)-Material, einem gerichtet erstarrten (DS)-Material, einem gleichachsigen Kristall (EX)-Material und Kombinationen davon ausgewählt ist.

9. Verfahren (100) nach einem der Ansprüche 1 bis 8, wobei der Lötspalt (303) klein genug ist, um eine Zugfestigkeit von mehr als 500 MPa bei Raumtemperatur bereitzustellen.

10. Verfahren (100) nach einem der Ansprüche 1 bis 9, wobei das Hartlötmaterial ein Material umfasst, das aus der Gruppe bestehend aus Gold, Kupfer, Silber, Platin, Palladium, Nickel, Titan, Vanadium, Zirkonium, Kobalt und Kombinationen davon ausgewählt ist.

11. Verfahren (100) nach einem der Ansprüche 1 bis 10, wobei das Sintern (105) bei einer Temperatur zwischen 982 und 1260 °C (1800 und 2350 °F) durchgeführt wird.

12. Verfahren (100) nach einem der Ansprüche 1 bis 11, wobei das Hartlöten (107) bei einer Temperatur zwischen 982 und 1288 °C (1800 und 2350 °F) durchgeführt wird.

13. Verfahren (100) nach einem der Ansprüche 1 bis 12, wobei die Komponente (201) eine Turbinenkomponente (201) ist, die aus der Gruppe bestehend aus mindestens einem von Laufschaufeln (Schaufeln), Leitschaufeln (Düsen), Deckbändern, Brennkammereinlagen und Übergangskanälen ausgewählt ist.

14. Behandelte Superlegierungsturbinenkomponente (201), umfassend:
eine Oberfläche mit einem sich verjüngenden Schlitz (204);
einen Einsatz (301), der in den sich verjüngenden Schlitz (204) mit einem Lötspalt (303) im Bereich von 0,0127 bis 0,254 mm (0,0005 bis 0,01 Zoll) zwischen einer Außenfläche des Einsatzes (301) und einer Innenfläche des sich verjüngenden Schlitzes (204) positioniert wird; und
eine Lötstelle, die ein Hartlötmaterial umfasst, das in dem Lötspalt (303) positioniert ist, wobei das Hartlötmaterial auf der Außenfläche des Einsatzes (301) gesintert wurde, wobei die Superlegierungsturbinenkomponente (201) eine Diffusionsschicht (302) zwischen dem Einsatz (301) und der Superlegierungsturbinenkomponente (201) aufweist.

## Revendications

1. Procédé (100) de traitement d'un composant de turbine en superalliage (201) comprenant les étapes consistant à :
usiner (101) une fente effilée (204) dans le composant (201) pour retirer une partie (203) du composant (201) ;
mesurer (102) la fente effilée (204) pour déterminer les dimensions de la fente effilée (204) ;
former (103) un insert (301) pour avoir une géométrie correspondante à la fente effilée (204) avec un espace de brasage (303) allant de 0,0127 à 0,254 mm (0,0005 à 0,01 pouce) entre une surface externe de l'insert (301) et une surface interne de la fente effilée (204) ;
déposer (104) une couche d'un matériau de brasage sur la surface externe de l'insert (301) ;
fritter (105) la couche du matériau de brasage sur la surface externe de l'insert (301) pour fabriquer une couche de diffusion (302) ;
positionner (106) l'insert (301) dans la fente effilée (204) ; et
braser (107) le composant (201) pour joindre l'insert (301) au composant (201).

2. Procédé (100) selon la revendication 1, dans lequel la mesure (102) comprend l'utilisation d'un système de mesure sélectionné dans le groupe constitué de système de mesure 3D en lumière blanche, système de mesure 3D en lumière bleue, système de mesure à base de laser, et de combinaisons de ceux-ci.

3. Procédé (100) selon la revendication 1 ou 2, dans lequel la formation (103) de l'insert (301) comprend un processus choisi dans le groupe constitué par le forage post-fabrication, l'usinage par décharge électrique (EDM), le forage laser, le forage mécanique, le forage vibratoire, le broyage, le broyage par commande numérique informatique, la découpe par jet d'eau, la découpe par jet abrasif, le poinçonnage, la formation par une technique de fabrication additive, l'impression 3D et leurs combinaisons.

4. Procédé (100) selon l'une quelconque des revendications 1 à 3, dans lequel le dépôt (104) comprend un processus choisi dans le groupe constitué par le spray de poudre, le le dépôt de ruban ou de feuille, le dépôt physique en phase vapeur (PVD), le dépôt chimique en phase vapeur (CVD), le spray thermique, l'électrodéposition, le trempage à chaud, le trempage à froid, le dépôt par laser, le dépôt par soudage, et leurs combinaisons.

5. Procédé (100) selon l'une quelconque des revendications 1 à 4, dans lequel une épaisseur de la couche est identique à l'espace de brasage (303) espacée entre la surface externe de l'insert (301) et la surface interne de la fente effilée (204).

6. Procédé (100) selon l'une quelconque des revendications 1 à 5, dans lequel le composant (201) comprend un matériau en superalliage choisi parmi le groupe constitué d'un superalliage à base de nickel, un superalliage à base de cobalt, un superalliage à base de fer, un superalliage à base de titane, et des combinaisons de ceux-ci.

7. Procédé (100) selon l'une quelconque des revendications 1 à 6, dans lequel le composant (201) comprend un matériau choisi dans le groupe constitué d'un matériau monocristallin (SX), un matériau à solidification directionnelle (DS), un matériau à cristaux équiaxes (EX), et des combinaisons de ceux-ci.

8. Procédé (100) selon l'une quelconque des revendications 1 à 7, dans lequel l'insert (301) comprend un matériau choisi dans le groupe constitué par un matériau monocristallin (SX), un matériau à solidification directionnelle (DS), un matériau à cristaux équiaxes (EX), et des combinaisons de ceux-ci.

9. Procédé (100) selon l'une quelconque des revendications 1 à 8, dans lequel l'espace de brasage (303) est suffisamment petit pour fournir une résistance à la traction supérieure à 500 MPa à température ambiante.

10. Procédé (100) selon l'une quelconque des revendications 1 à 9, dans lequel le matériau de brasage comprend un matériau choisi dans le groupe constitué d'or, cuivre, argent, platine, palladium, nickel, titane, vanadium, zirconium, cobalt, et des combinaisons de ceux-ci.

11. Procédé (100) selon l'une quelconque des revendications 1 à 10, dans lequel le frittage (105) est conduit à une température comprise entre 982 et 1260 °C (1800 et 2300 °F).

12. Procédé (100) selon l'une quelconque des revendications 1 à 11, dans lequel le brasage (107) est conduit à une température comprise entre 982 et 1288 °C (1800 et 2350 °F).

13. Procédé (100) selon l'une quelconque des revendications 1 à 12, dans lequel le composant (201) est un composant de turbine (201) choisi dans le groupe constitué d'au moins l'un parmi des lames (godets), des aubes (buses), des viroles, des chemises de chambre de combustion et des conduits de transition.

14. Composant de turbine en superalliage traité (201), comprenant :
une surface ayant une fente effilée (204) ;
un insert (301) positionné dans la fente effilée (204) avec un espace de brasage (303) allant de 0,0127 à 0,254 mm (0,0005 à 0,01 pouce) entre une surface externe de l'insert (301) et une surface interne de la fente effilée (204) ; et
un joint de brasage comprenant un matériau de brasage positionné dans l'espace de brasage (303), le matériau de brasage ayant été fritté sur la surface externe de l'insert (301), le composant de turbine en superalliage (201) ayant une couche de diffusion (302) entre l'insert (301) et le composant de turbine en superalliage (201).
